Europäisches Patentamt

European Patent Office

Office européen des brevets

(19)

(11) **EP 0 633 454 B1**

(12) **EUROPÄISCHE PATENTSCHRIFT**

(45) Veröffentlichungstag und Bekanntmachung des Hinweises auf die Patenterteilung:
**28.08.1996   Patentblatt 1996/35**

(51) Int Cl.$^6$: **G01D 5/248**, G01D 5/22, H03B 5/12

(21) Anmeldenummer: **93110750.2**

(22) Anmeldetag: **06.07.1993**

(54) **Schaltungsanordnung zur Bestimmung des Übertragungsmasses einer variablen Übertragungsschaltung**

Circuit arrangement for determining the degree of coupling in a variable transmission system

Circuit pour déterminer le degré de couplage dans un système de transmission variable

(84) Benannte Vertragsstaaten:
**AT BE CH DK ES FR GB GR IE IT LI LU MC NL PT SE**

(43) Veröffentlichungstag der Anmeldung:
**11.01.1995   Patentblatt 1995/02**

(73) Patentinhaber: **MFP MESSTECHNIK UND FERTIGUNGSTECHNOLOGIE GmbH D-31515 Wunstorf (DE)**

(72) Erfinder: **Patzke, Robert Dr. Ing. D-31515 Wunstorf (DE)**

(74) Vertreter: **Patentanwälte Thömen & Körner Zeppelinstrasse 5 30175 Hannover (DE)**

(56) Entgegenhaltungen:
**DE-A- 2 234 757          DE-A- 3 903 278**

Bemerkungen:
Die Akte enthält technische Angaben, die nach dem Eingang der Anmeldung eingereicht wurden und die nicht in dieser Patentschrift enthalten sind.

**Beschreibung**

Die Erfindung betrifft eine Schaltungsanordnung zur Bestimmung des Übertragungsmaßes einer variablen Übertragungsschaltung nach dem Oberbegriff des Anspruchs 1.

Eine derartige Schaltung ist aus der DE-OS 22 34 757 bekannt. Sie umfaßt einen Integrator, einen Komparator und eine veränderbare Rückkopplungseinrichtung. Diese Schaltung erfordert als notwendige Bedingung für das Erlangen einer linearen Frequenzabhängigkeit, daß die in der Rückkopplungsschleife benutzte Anordnung ein frequenzunabhänges Übertragungsmaß besitzt. Es können jedoch frequenzabhängige Anordnungen Verwendung finden, wenn zusätzliche kompensierende Schaltungen angewendet werden.

In einer ersten Ausführung der bekannten Schaltung ist die variable Rückkopplungseinrichtung durch einen ohmschen Spannungsteiler gebildet, der ein frequenzunabhänges Übertragungsmaß besitzt und daher keiner Kompensationsschaltung bedarf. In einer zweiten Ausführung hingegen ist ein Differentialübertrager eingesetzt. Der Grund für den Einsatz des Differentialübertragers besteht in dessen Eignung als Wegaufnehmer, wobei die Lage des Kerns des Übertragers dessen Übertragungsmaß bestimmt. Da der Differentialübertrager ein frequenzabhänges Übertragungsmaß besitzt, ist bei der zweiten Ausführung der bekannten Schaltung eine kompensierende Schaltung vorgesehen und für eine ordnungsgemäße Funktion auch zwingend erforderlich.

Bei dem Differentialübertrager der bekannten Schaltung wird lediglich die die Spannungsdifferenz der Sekundärwicklungen bildende Eigenschaft ausgenutzt, nicht aber das elektrische differentielle Verhalten des Übertragers, das auch ein einfacher, nicht als Differentialübertrager ausgebildeter Transformator hat. Im Zusammenhang mit der bekannten Schaltung ist das elektrische differentielle Verhalten des Differentialübertragers vielmehr störend und muß kompensiert werden.

Aus der DE-PS 23 57 791 und der DE-PS 25 15 256 ist jeweils eine weitere Schaltungsanordnung zur Bestimmung des Übertragungsmaßes einer variablen Übertragungsschaltung bekannt. Die Übertragungsschaltung ist hier durch eine variable Induktivität oder alternativ durch einen Integrator mit einem in Serie geschalteten variablen Transformator gebildet. Die Induktivität bzw. der Kopplungsfaktor des Transformators bestimmt die Frequenz eines Oszillators, der aus der Reihenschaltung eines Komparators mit Hysterese, der variablen Übertragungsschaltung und eines Integrators gebildet ist.

Zusammen mit der Frequenz des so gebildeten Oszillators verändert sich auch die Amplitude der an der Übergungsschaltung anstehenden Wechselspannung. Eine Auswerteschaltung in Form eines Gleichrichters ist mit der Übertragungsschaltung verbunden. Der Wert der gleichgerichteten Wechselspannung entspricht dann dem Übertragungsmaß der Übertragungsschaltung.

Bei einer anderen, aus der WO 89/04949 bekannten Schaltungsanordnung zur Bestimmung des Übeitragungsmaßes einer variablen Übertragungsschaltung ist diese als Differentialtransformator ausgebildet. Die Primärwicklung des Differentialtransformators speist ein Oszillator, der eine sinusförmige Spannung erzeugt. An die Sekundärwicklungen sind Auswerteschaltungen angeschlossen, die die Signale der Sekundärwicklungen getrennt gleichrichten, filtern und die analogen Signale in digitale Signale umwandeln, die dann angezeigt werden können.

Auch die DE-PS 29 24 092 und die DE-OS 40 17 843 befassen sich mit Schaltungsanordnungen zur Bestimmung des Übertragungsmaßes einer variablen Übertragungsschaltung.

Die Gemeinsamkeit der bekannten Schaltungen besteht darin, daß analoge Größen erzeugt werden, die zur Gewinnung digitaler Größen einer Analog-Digital-Wandlung unterzogen werden müssen. Dadurch entstehen aber zusätzliche Ungenauigkeiten, insbesondere durch temperatur- und alterungsbedingte Spannungsdrift derartiger Analog-Digital-Wandler.

Der Erfindung liegt die Aufgabe zugrunde, eine Schaltungsanordnung der eingangs genannten Art dahingehend zu verbessern, daß bei einfachem Schaltungsaufwand eine digitale Erfassung des Übertragungsmaßes bei hoher Genauigkeit erzielbar ist.

Diese Aufgabe wird bei einer Schaltungsanordnung nach dem Oberbegriff des Anspruchs 1 durch die im Kennzeichen angegebenen Merkmale gelöst.

Variable Übertragungsschaltungen mit differentiellem Übertragungsverhalten können als einfache Induktivität, als einfacher Transformator, als Differentialtransformator mit beweglichem Kern oder beweglichem Kurzschlußring, als Kapazität oder komplexe elektronische Schaltung realisiert sein.

Durch die Addition der Ausgangssignale der Übertragungsschaltung und des Komparators am Eingang des Integrators ergibt sich ein überlagertes Ausgangssignal am Ausgang des Integrators, das je nach Vorzeichen des Übertragungsmaßes ein früheres oder späteres Umschalten des Komparators bewirkt. Dies entspricht einer virtuellen Veränderung der Schwellenspannung des Komparators und beeinflußt die Periodendauer des Ausgangssignals. Die Periodendauer des Ausgangssignals des Komparators, das eine Rechteckform besitzt, ist somit unmittelbar vom Übertragungsmaß abhängig. Durch Messung der Periodendauer oder der Frequenz kann somit digital ein Wert bestimmt werden, der dem Übertragungsmaß entspricht. Die Gewinnung eines analogen Signals und Umwandlung in ein digitales Signal durch Analog-Digital-Wandlung entfällt.

Gemäß einer Weiterbildung sind die frequenzbestimmenden Schaltungselemente des Oszillators so bemessen, daß die mittlere Periodendauer $T_K$ des Oszillatorsignals wesentlich größer als die Zeitkonstante $T_T$ der Übertragungsschaltung ist. Bei der Bemessung wird zweckmäßig berücksichtigt, daß der Ausdruck $(1 - \exp(-T_K/2T_T))$ bis auf eine in der Größenordnung der erzielbaren Meßauflösung der Schaltungsanordnung liegende Abweichung gegen 1 geht.

Bei dieser Bemessung ergibt sich eine praktisch lineare Abhängigkeit zwischen der Periodendauer des Oszillatorsignals und dem Übertragungsmaß. Der verbleibende Restfehler liegt in der Größenordnung der Meßauflösung und kann daher bei der Auswertung außer Betracht bleiben.

Unter Berücksichtigung dieser Bemessung kann die Zähleranordnung oder der Rechner das Übertragungsmaß aus der Periodendauer des Oszillatorsignals nach folgender mathematischer Form ermitteln:

$$k_T = 1/k_S * (1 - T_K/T_0),$$

Dabei sind $k_S$ und $T_0$ vom Übertragungsmaß $k_T$ unabhängige schaltungsspezifische Konstanten.

Eine vorteilhafte Weiterbildung sieht vor, daß zwischen dem Ausgang des Komparators und dem Eingang der Übertragungsschaltung ein Umschalter angeordnet ist, welcher wahlweise eine direkte Verbindung oder eine Verbindung über einen Inverter schafft. Die Zähleranordnung oder der Rechner ermitteln das Übertragungsmaß dann aus der Periodendauer des Oszillatorsignals in der einen Schalterstellung und der Periodendauer des Oszillatorsignals in der anderen Schaltung nach folgender mathematischer Funktion:

$$k_T = 1/k_S * (T_{K2}/2T_0 - T_{K1}/2T_0),$$

Dabei sind $k_S$ und $T_0$ vom Übertragungsmaß $k_T$ unabhängige schaltungsspezifische Konstanten. $T_0$ ist in einem vorangehenden oder zyklischen Kalibriervorgang gemäß folgender mathematischer Funktion ermittelbar:

$$2T_0 = T_{K1} + T_{K2}.$$

Durch diese Maßnahme können Schaltungseigenschaften wie Drift, Temperaturgang oder Unsymmetrien der Übertragungsschaltung kompensiert werden. Die Kalibrierung kann außerdem in einfacher Weise überprüft und bei größeren Abweichungen wiederholt werden.

Wird für die Auswerteschaltung eine Zähleranordnung eingesetzt, so kann diese einen ersten, setzbaren Zähler und einen zweiten mit einem Referenztakt getakteten Zähler aufweisen. Dabei ist das Oszillatorsignal an den Takteingang des ersten Zählers gelegt, der Ausgang des ersten Zählers mit dem Tor des zweiten Zählers verbunden und der Referenztakt an den Takteingang des zweiten Zählers gelegt.

Es besteht so die einfache Möglichkeit, im ersten Zähler die Schwingungsperioden in der einen oder der anderen Stellung des Schalters aufwärts, abwärts oder von einem vorgesetzten Wert an aufwärts oder abwärts zu zählen. Im zweiten Zähler kann durch Vergleich mit einem Referenztakt die Periodendauer ermittelt werden, wobei durch die Wahl des Referenztaktes auch eine Berücksichtigung der Proportionalitätsfaktoren erfolgen kann, so daß das angezeigte Ergebnis unmittelbar dem Übertragungsmaß entspricht.

Als weitere Variante kann zwischen dem Ausgang des Komparators und dem Eingang der Übertragungsschaltung ein Schalter angeordnet sein, welcher wahlweise eine Verbindung oder eine Unterbrechung schafft.

Auf diese Weise ist es möglich, die Leerlaufperiodendauer der Schaltungsanordnung zu messen und damit die Schaltungseigenschaften zur Bestimmung des Proportionalitätsfaktors ohne Beeinflussung durch die Übertragungsschaltung zu ermitteln. Außerdem kann auch bei einer Übertragungsschaltung mit symmetrischem Verhalten, bei der also sowohl ein positives als auch ein negatives Übertragungsmaß einstellbar ist, der Symmetriearbeitspunkt bestimmt werden.

Der Integrator kann als invertierender Verstärker ausgebildet sein, zwischen dessen Ausgang und invertierendem Eingang eine Kapazität angeordnet ist. Der Addierer kann dabei einen ersten und zweiten Ladewiderstand umfassen, die an den invertierenden Eingang angeschlossen sind.

Dadurch lassen sich die addierende und die integrierende Funktion mit einem gemeinsamen aktiven Schaltelement realisieren.

Weiterhin ist es möglich, daß der Komparator ein mitgekoppelter nicht invertierender Verstärker ist.

Es ergeben sich dadurch eindeutige Umschaltpunkte mit steilen Umschaltflanken, die für die digitale Verarbeitung und Auswertung der Signale vorteilhaft sind.

Im Falle der Ausbildung der Übertragungsschaltung als Differentialtransformator, der besonders für eine Anwendung der Übertragungsschaltung als Wegaufnehmer geeignet ist, ist der Eingang der Übertragungsschaltung mit der Primärwicklung und der Ausgang der Übertragungsschaltung mit den Sekundärwicklungen verbunden. Dabei sind die Sekundärwicklungen gegensinnig in Serie geschaltet.

Diese Ausgestaltung ermöglicht es, die Ausgangssignale der Sekundärwicklungen gemeinsam auszuwerten, wobei das Übertragungsmaß sowohl positive als auch negative Werte einnehmen kann.

Weiterbildungen und vorteilhafte Ausgestaltungen der Erfindung ergeben sich aus den Ansprüchen, der weiteren Beschreibung und der Zeichnung, an Hand der die Erfindung näher erläutert wird.

In der Zeichnung zeigen:

Fig. 1    ein Blockschaltbild einer bevorzugten Ausführung,

Fig. 2    eine Prinzipschaltung eines kombinierten Addierers und Integrators zusammen mit einer als Differentialtransformator ausgebildeten Übertragungsschaltung,

Fig. 3    eine grafische Darstellung der Signalverläufe am Eingang der in Fig. 2 dargestellten Schaltung und der daraus resultierenden Ströme am invertierenden Eingang des Verstärkers,

Fig. 4    eine grafische Darstellung eines Ausgangssignals bei einer Schaltung gemäß Fig. 2 für ein negatives Übertragungsmaß,

Fig. 5    eine entsprechende Darstellung für ein positives Übertragungsmaß und

Fig. 6    eine grafische Darstellung des Signalverlaufs am Eingang des Komparators mit Darstellung der Schaltschwellen.

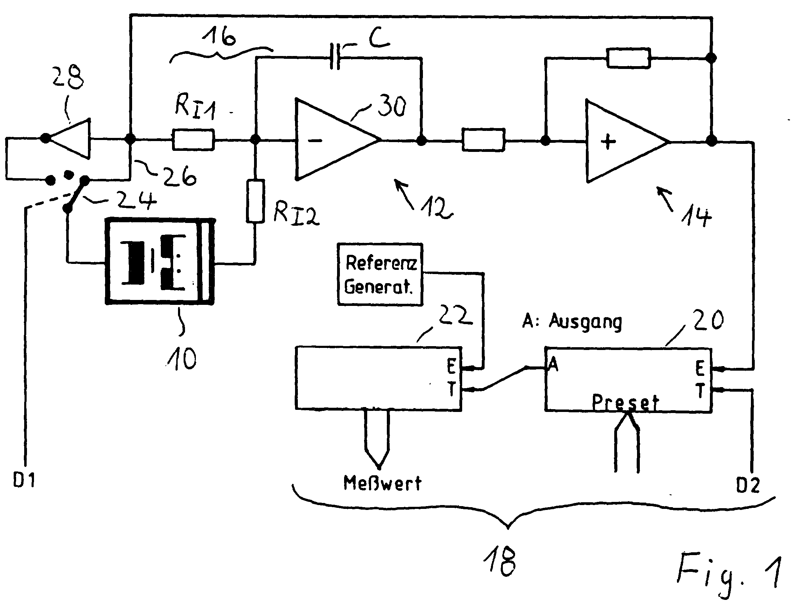

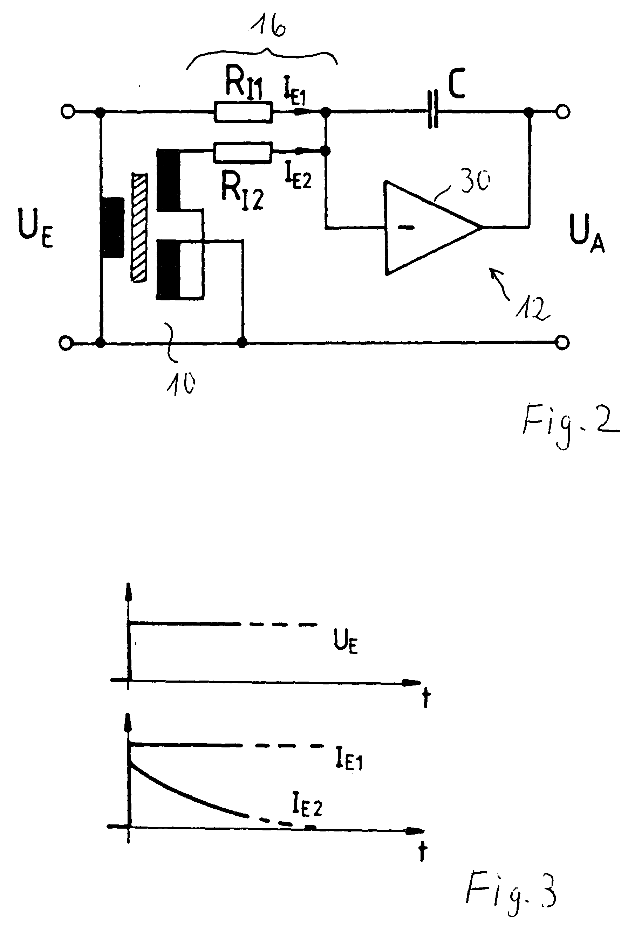

Die in Fig. 1 dargestellte Schaltungsanordnung zur Bestimmung des Übertragungsmaßes einer variablen Übertragungsschaltung umfaßt einen Differentialtransformator 10 sowie die Serienschaltung eines Integrators 12 und eines Komparators 14. Der Ausgang des Komparators 14 ist über einen Addierer 16 mit den Eingang des Integrators 12 verbunden. Zusätzlich ist der Komparator 14 mit dem Eingang des Differentialtransformators 10 verbunden und der Ausgang des Differentialtransformators 10 ist über den Addierer 16 mit dem Eingang des Integrators 12 verbunden.
Am Ausgang des Komparators 14 befindet sich eine Auswerte- und Anzeigeschaltung 18, die aus einem ersten Zähler 20 und einem zweiten Zähler 22 besteht.
Zwischen dem Ausgang des Komparators 14 und dem Eingang des Differentialtransformators 10 befindet sich ein Umschalter 24, der wahlweise eine direkte Verbindung 26 oder eine Verbindung über einen Inverter 28 schafft. Der Schalter 24 kann auch eine dritte Schaltstellung einnehmen, in der keine Verbindung zum Differentialtransformator 10 besteht.
Zur Erläuterung der Wirkungsweise sei zunächst davon ausgegangen, daß der Schalter 24 sich in der mittleren Schaltstellung befindet, somit also der aus dem Komparator 14 und dem Integrator 12 gebildete Oszillator im Leerlauf arbeitet. Bei einem positiven Ausgangszustand des Komparators 14 fließt in den invertierenden Eingang des Integrators 12 über den Addierer 16 ein Strom, der die Ausgangsspannung am Integrator 12 stetig zu negativen Werten hin verändert. Dabei wird schließlich die Schaltschwelle des Komparators 14 erreicht, worauf dieser seinen Ausgangszustand vom ursprünglich positiven zum negativen Wert ändert.
Nunmehr fließt ein Strom umgekehrter Polarität über den Addierer 16 in den invertierenden Eingang des Integrators 12 und die Ausgangsspannung am Integrator 12 ändert sich in umgekehrter Richtung, das heißt zu positiven Werten hin. Sobald wieder die Schaltschwelle des Komparators 14 erreicht ist, schaltet dessen Ausgang auf umgekehrte Polarität. Dieser Vorgang wiederholt sich periodisch. Am Ausgang des Integrators 12 ist ein dreieckförmiges Signal abgreifbar, während am Ausgang des Komparators 14 ein Rechtecksignal erscheint. Die Periodendauer der Signale wird im wesentlichen durch die Zeitkonstante des Integrators 12 und die Schwellspannung des Komparators 14 bestimmt. Diese Periodendauer kann über die Zähleranordnung 18 gemessen und angezeigt werden.
Wird der Schalter 24 in die linke oder rechte Stellung gebracht, so wird auch der Primärwicklung des Differentialtransformators 10 das Ausgangssignal des Komparators 14 zugeführt. Der Differentialtransformator 10 hat differenzierende Eigenschaften. Abhängig von der Polarität und der Größe seines Übertragungsmaßes erhält der invertierende Eingang des Integrators 12 einen zusätzlichen Strom, der sich dem vom Komparator 14 unmittelbar stammenden Strom überlagert. Dies führt dazu, daß das Ausgangssignal des Integrators 12 früher oder später als im Leerlauf die Umschaltschwellen des Komparators 14 erreicht. Als Folge davon ändert sich die Periodendauer der erzeugten Wechselspannung. Durch Messung der Periodendauer mit Hilfe der Zähleranordnung 18 läßt sich nunmehr das Übertragungsmaß bestimmen.
Die mathematischen Zusammenhänge sowie die Herleitung der mathematischen Funktion, die für den Zusammenhang zwischen der Periodendauer und dem Übertragungsmaß angewendet wird, wird in Verbindung mit den Darstellungen gemäß Fig. 2 bis 6 beschrieben.
Fig. 2 zeigt dazu als Teil aus Fig. 1 den Komparator 12 mit der Additionsschaltung 16 sowie dem Differentialtransformator 10. Der Integrator 12 umfaßt einen invertierenden Verstärker 30, eine Kapazität C, und der Addierer 16 umfaßt einen Widerstand $R_{I1}$ und einen Widerstand $R_{I2}$. An Eingangsklemmen der Schaltung wird eine Spannung $U_E$ angelegt und an den Ausgangsklemmen erscheint eine Spannung $U_A$.
Wird gemäß Fig. 3 eine Spannung angelegt, die im Zeitpunkt t = 0 einen Sprung von 0 auf $U_E$ durchführt und anschließend den Wert $U_E$ beibehält, so fließt über den Widerstand $R_{I1}$ ein konstanter Strom $I_{E1}$ und über den Widerstand $R_{I2}$ ein Strom $I_{E2}$. Der Strom $I_{E2}$ entsteht dadurch, daß die Ausgangsspannung des Differentialtransformators 10 der Spannung $U_E$ multipliziert mit dem Übertragungsmaß $k_T$ im Schaltaugenblick folgt und anschließend aufgrund der differenzierenden Wirkung des Differentialtransformators 10 nach einer e-Funktion abklingt. Dabei ist im Widerstand $R_{I2}$ auch der Innenwiderstand des DifferentialtransformatorS 10 enthalten.

Für den Strom $I_{E2}$ kann die Gleichung

$$I_{E2} = k_T \, U_E/R_{I2} \, \exp(-t/T_T),$$

mit $T_T$: Zeitkonstante und $k_T$: Übertragungsmaß angegeben werden. Der Integrator 12 liefert die Ausgangsspannung $U_A$, die sich zu

$$U_A = - 1/C \int (I_{E1} + I_{E2}) \, dt =$$

$$= U_A(0) - t \, U_E/CR_{I1} - k_T \, U_E \, (1-\exp(-t/T_T)) \, T_T/CR_{I2}$$

ergibt.

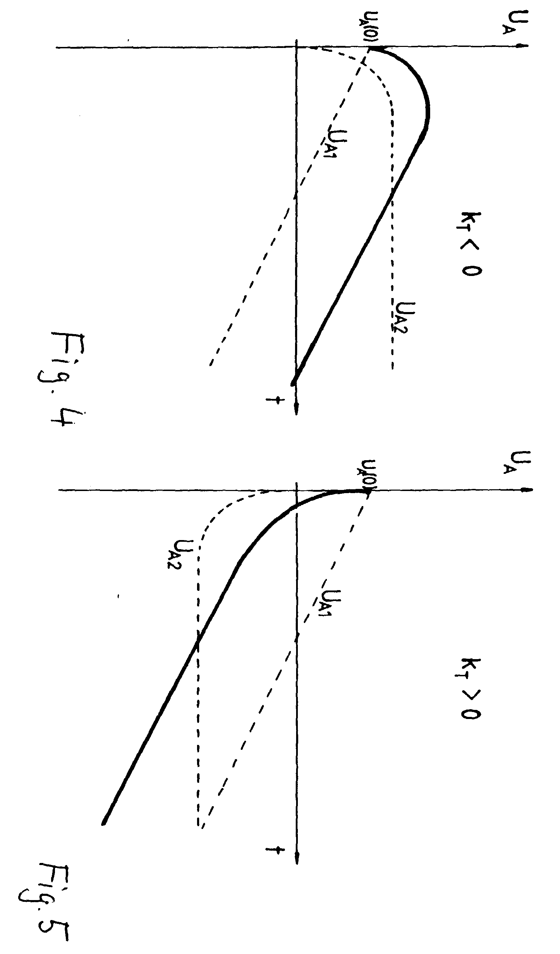

Der Verlauf der Spannung $U_A$ ist in den Figuren 4 und 5 dargestellt. Dabei ist die ausgezogene Linie die resultierende Spannung, während die gestrichelten Linien die aus den Eingangsströmen $I_{E1}$ und $I_{E2}$ hervorgegangenen Anteile $U_{A1}$ und $U_{A2}$ darstellen.

Die Spannungsverläufe gemäß Fig. 4 und Fig. 5 unterscheiden sich lediglich dadurch, daß in Fig. 4 ein negatives Übertragungsmaß $k_T$ und in Fig. 5 ein positives Übertragungsmaß $k_T$ bei ansonsten gleichen Eingangsspannungen $U_E$ angenommen wurde.

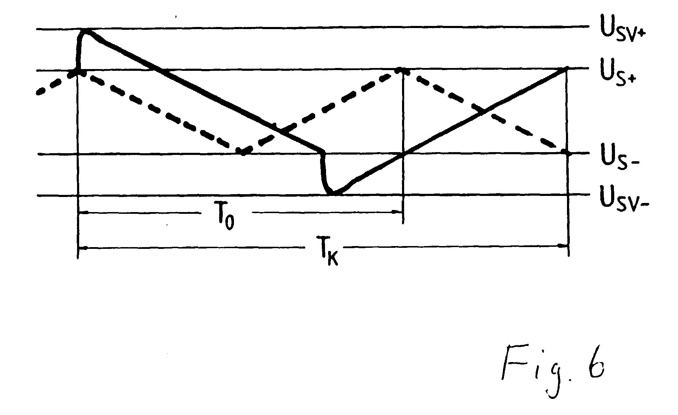

Unter Berücksichtigung des Spannungsverlaufs aus den Figuren 4 und 5, die hier für einen einzigen positiven Spannungssprung dargestellt sind, ergibt sich für ein kontinuierliches Signal der Schaltung gemäß Fig. 1 eine Darstellung gemäß Fig. 6. Dabei zeigt die gestrichelte Linie einen Spannungsverlauf ohne die Wirkung des Differentialtransformators 10 und die durchgezogene Linie einen Spannungsverlauf in Verbindung mit dem Differentialtransformator 10. Diese Spannungsverläufe kommen wie folgt zustande.

Erreicht die Ausgangsspannung $U_A$ des Integrators 12 die positive Schaltschwelle des Komparators 14, so schaltet dieser von der negativen zur positiven Versorgungsspannung. Ohne den extra Schaltungsteil mit dem Differentialtransformator 10 würde die Ausgangsspannung $U_A$ des Integrators 12 von der oberen Schaltschwelle $U_{S+}$ des Komparators 14 linear mit der Zeit zu seiner unteren Schaltschwelle $U_{S-}$ verlaufen. Mit Differentialtransformator 10 und einem Übertragungsmaß $k_T$ ungleich 0 hat die Ausgangsspannung $U_A$ einen anderen Vorlauf. Der Dreieckspannung ist der in Fig. 4 gestrichelt eingezeichnete Spannungsverlauf $U_{A2}$, der aus dem Eingangsstrom $I_{E2}$ resultiert und die Form $k_T(1-\exp(-t/T_T))$ hat, zu überlagern. Die Ausgangsspannung ist daher, je nach Vorzeichen des Übertragungsmaßes, kurze Zeit nach dem Umschalten des Komparators größer oder kleiner als der ohne Differentialtransformator 10 zu erwartende Wert.

Ein negatives Übertragungsmaß führt zu einer Erhöhung der Integratorausgangsspannung. Es dauert jetzt länger, bis die Ausgangsspannung die untere Schaltschwelle des Komparators erreicht. Dies entspricht einer virtuellen Erhöhung der positiven Schwellenspannung des Komparators um genau den Betrag:

$$U_{S++} = k_T \, U_E \, (1-\exp(-T_K/2T_T) \, T_T/CR_{I2},$$

worin $T_K$ die Periodendauer des Ausgangssignals ist. Wird durch entsprechende Wahl von C die Periodendauer groß gegen die Zeitkonstante $T_T$ des Differentialtransformators gewählt, so kann der Term $(1 - \exp(-T_K/2T_T))$ gegen 1 vernachlässigt werden. Die für die Berechnung der Periodendauer zu verwendende, virtuelle Schaltschwelle des Komparators ergibt sich damit zu:

$$U_{SV+} = U_{S+} - k_T \, U_E \, T_T/CR_{I2}$$

und ist linear vom Übertragungsmaß $k_T$ des Differentialtransformators 10 abhängig. Für die Periodendauer des Rechtecksignals am Ausgang des Komparators 14 kann der Ansatz

$$T_K = T_0 - k_T \, T_1 = T_0 \, (1 - k_T \, k_S)$$

gewählt werden, worin $k_S$ und $T_0$ schaltungsspezifische Konstanten sind und nicht von, Übertragungsmaß des Differentialtransformators 10 abhängen. Die Messung der Periodendauer erfolgt durch das Auszählen von Impulsen aus einem Referenztaktgenerator in dem Zähler 22 der Zähleranordnung 18. Die Torschaltung des Zählers 22 wird mit dem Ausgangssignal des Komparators 14 über den Zähler 20 bedient.

Durch Umstellung der obigen Formel ergibt sich das gesuchte Übertragungsmaß $k_T$ aus der Periodendauer $T_K$ des Oszillatorsignals nach folgender mathematischer Funktion:

$$k_T = 1/k_S \, {}^* \, (1 - T_K/T_0),$$

Bei dieser Funktion ist davon ausgegangen, daß die gesamte Messung nur in einer der beiden Schalterstellungen des Schalters 24 vorgenommen wird, in dem also entweder eine direkte Verbindung 26 oder eine Verbindung über den Inverter 28 zwischen dem Ausgang des Komparators 14 und dem Eingang des Differentialtransformators 10 besteht.

Wenn jedoch eine erste Messung in der ersten und eine zweite Messung in der zweiten Schalterstellung vorgenommen wird, ergeben sich unterschiedliche Werte für die Periodendauer, nämlich

$$T_{K1} = T_0 \, (1 - k_T \, k_S) \text{ und } T_{K2} = T_0 \, (1 + k_T \, k_S).$$

Aus der Summe $T_{K2} + T_{K1}$ ergibt sich mit $2T_0$ ein Wert, der nicht vom Übertragungsmaß des Differentialtransformators 10 abhängig ist und damit die Eigenschaften der Schaltung allein angibt. Hieraus können die Drift der Schaltung bestimmt und entsprechende Korrekturfaktoren abgeleitet werden.

Aus der Differenz $T_{K2} - T_{K1}$ ergibt sich ein Wert, der nach

$$T_{K2} - T_{K1} = k_T \, k_S \, 2T_0$$

direkt proportional zum Übertragungsmaß des Differentialtransformators 10 ist. Dieser Wert enthält keinen schaltungsabhängigen Offset mehr. Der Proportionalitätsfaktor $k_S 2T_0$ ist allerdings von den Schaltungseigenschaften abhängig und ein Term $K_S$ oder $T_0$ kann aus der Summe der Meßwerte ermittelt werden, womit der Meßwert später zu korrigieren ist. In der Praxis wird dieser Faktor in einem Kalibriervorgang ermittelt. Überschreitet $T_0$ bei der Messung einen vorgegebenen Grenzwert, so wird neu kalibriert.

Durch Umstellung der obigen Formel kann daher eine von der Temperatur- und Spannungsdrift der Schaltung unabhängige Messung des Übertragungsmaßes $k_T$ in Abhängigkeit der Periodendauern $T_{K1}$ und $T_{K2}$ des Oszillatorsignals nach folgender mathematischer Funktion ermittelt werden:

$$k_T = 1/k_S \, {}^* \, (T_{K2}/2T_0 - T_{K1}/2T_0).$$

**Patentansprüche**

1. Schaltungsanordnung zur Bestimmung des Übertragungsmaßes ($K_T$) einer variablen Übertragungsschaltung (10) mit einem den Eingang der Übertragungsschaltung (10) speisenden Oszillator, welcher eine Serienschaltung aus einem Integrator (12) und einem Komparator (14) umfaßt, wobei der Ausgang des Komparators (14) mit dem Eingang der Übertragungsschaltung (10) und auch über einen Addierer (16) zusammen mit dem Ausgang der Übertragungsschaltung (10) mit dem Eingang des Integrators (12) verbunden ist, dadurch gekennzeichnet,

    a) die Übertragungsschaltung (10) ein differentielles elektrisches Übertragungsverhalten aufweist, so daß deren Übertragungsmaß ($K_T$) sich linear in der Periodendauer ($T_K$) des Oszillators abbildet, wobei

    b) die Periodendauer ($T_K$) des Oszillators mittels einer als Auswerte- und Anzeigeschaltung dienenden Zählerschaltung (18) oder eines Rechners gemessen wird,

    c) in dem mit Hilfe von vom Übertragungsmaß ($K_T$) unabhängigen schaltungsspezifischen Konstanten ($T_1$, $T_0$), die entweder aus Schaltungsparametern berechenbar sind oder in einem vorangehenden oder zyklischen Kalibriervorgang gemessen wurden, das Übertragungsmaß ($K_T$) aus der Differenz der Periodendauer ($T_0$) des Oszillators bei abgeschalteter Übertragungsschaltung (10) und aus der Periodendauer ($T_K$) bei eingeschalteter Übertragungsschaltung (10) ermittelt wird und diese Differenz auf die schaltungsspezifische Konstante ($T_1$) bezogen wird.

2. Schaltungsanordnung nach Anspruch 1, dadurch gekennzeichnet, daß die frequenzbestimmenden Schaltungselemente des Oszillators so bemessen sind, daß die mittlere Periodendauer $T_K$ des Oszillatorsignals wesentlich größer als die Zeitkonstante $T_T$ der Übertragungsschaltung ist, derart daß der Ausdruck $(1 - \exp(-T_K/2T_T))$ bis auf eine in der Größenordnung der erzielbaren Meßauflösung der Schaltungsanordnung liegende Abweichung gegen 1 geht.

3. Schaltungsanordnung nach Anspruch 2, dadurch gekennzeichnet, daß die Zähleranordnung (18) oder der Rechner das Übertragungsmaß $k_T$ aus der Periodendauer $T_K$ des Oszillatorsignals nach folgender mathematischer Funktion ermittelt:

$$k_T = 1/k_S \, {}^* \, (1 - T_K/T_0),$$

wobei $k_S$ und $T_0$ vom Übertragungsmaß $k_T$ unabhängige schaltungsspezifische Konstanten sind.

4. Schaltungsanordnung nach Anspruch 2, <u>dadurch gekennzeichnet</u>, daß zwischen dem Ausgang des Komparators (14) und dem Eingang der Übertragungsschaltung (10) ein Umschalter (24) angeordnet ist, welcher wahlweise eine direkte Verbindung (26) oder eine Verbindung über einen Inverter (28) schafft und daß die Zähleranordnung (18) oder der Rechner das Übertragungsmaß $k_T$ aus der Periodendauer $T_{K1}$ des Oszillatorsignals in der einen Schalterstellung und der Periodendauer $T_{K2}$ des Oszillatorsignals in der anderen Schalterstellung nach folgender mathematischer Funktion ermittelt:

$$k_T = 1/k_S * (T_{K2}/2T_0 - T_{K1}/2T_0),$$

wobei $k_S$ und $T_0$ vom Übertragungsmaß $k_T$ unabhängige schaltungsspezifische Konstanten sind und $T_0$ in einem vorangehenden oder zyklischen Kalibriervorgang gemäß folgender mathematischer Funktion ermittelbar ist:

$$2T_0 = T_{K1} + T_{K2}.$$

5. Schaltungsanordnung nach Anspruch 3 oder 4, <u>dadurch gekennzeichnet</u>, daß die Zähleranordnung (18) einen ersten, setzbaren Zähler (20) und einen zweiten, mit einem Referenztakt getakteten Zähler (22) aufweist, wobei das Oszillatorsignal an den Takteingang des ersten Zählers (20) gelegt ist, der Ausgang des ersten Zählers (20) mit dem Tor des zweiten Zählers (22) verbunden ist und der Referenztakt an den Takteingang des zweiten Zählers (22) gelegt ist.

6. Schaltungsanordnung nach einem der Ansprüche 1 bis 5, <u>dadurch gekennzeichnet</u>, daß zwischen dem Ausgang des Komparators (14) und dem Eingang der Übertragungsschaltung (10) ein Schalter (24) angeordnet ist, welcher wahlweise eine Verbindung oder eine Unterbrechung schafft.

7. Schaltungsanordnung nach einem der Ansprüche 1 bis 6, <u>dadurch gekennzeichnet</u>, daß der Integrator (12) ein invertierender Verstärker ist, zwischen dessen Ausgang und invertierendem Eingang eine Kapazität (C) angeordnet ist, und daß der Addierer (16) einen ersten ($R_{l1}$) und einen zweiten Ladewiderstand ($R_{l2}$) umfaßt, die an den invertierenden Eingang angeschlossen sind.

8. Schaltungsanordnung nach einem der Ansprüche 1 bis 7, <u>dadurch gekennzeichnet</u>, daß der Komparator (14) ein mitgekoppelter, nicht-invertierender Verstärker ist.

9. Schaltungsanordnung nach einem der Ansprüche 1 bis 8, wobei die Übertragungsschaltung (10) ein Differentialtransformator ist, <u>dadurch gekennzeichnet</u>, daß der Eingang der Übertragungsschaltung (10) mit der Primärwicklung und der Ausgang der Übertragungsschaltung (10) mit den gegensinnig in Serie geschalteten Sekundärwicklungen des Differentialtransformators (10) verbunden sind.

## Claims

1. Circuit arrangement for determining the degree of coupling ($K_T$) of a variable transmission system (10) comprising an oscillator supplying the input of the transmission system (10), which (oscillator) comprises a series circuit consisting of an integrator (12) and a comparator (14), wherein the output of the comparator (14) is connected to the input of the transmission system (10) and also, via an adder (16), together with the output of the transmission system (10) to the input of the integrator (12), characterized in that

   a) the transmission system (10) has a differential electrical transmission behaviour, so that its degree of coupling ($K_T$) appears linear in the period time ($T_K$) of the oscillator, wherein

   b) the period ($T_K$) of the oscillator is measured by means of a counter circuit (18) serving as evaluating and display circuit or by means of a computer,

   c) in which, by means of circuit-specific constants ($T_1$, $T_0$), independent of the degree of coupling ($K_T$), which either can be calculated from circuit parameters or have been measured in a preceding or cyclical calibration operation, the degree of coupling ($K_T$) is determined from the difference between the period ($T_0$) of the oscillator when the transmission system (10) is shut off and the period ($T_K$) when the transmission system (10) is switched on, and this difference is referred to the circuit-specific constant ($T_1$).

2. Circuit arrangement according to Claim 1, characterized in that the frequency-determining circuit elements of the oscillator are so designed that the mean period $T_K$ of the oscillator signal is substantially larger than the time constant $T_T$ of the transmission system, in such a way that the expression $(1 - \exp(-T_K/2T_T))$ tends to 1 to within a deviation lying in the order of value of the achievable measurement resolution of the circuit arrangement.

3. Circuit arrangement according to Claim 2, characterized in that the counter assembly (18) or the computer determines the degree of coupling $k_T$ from the period $T_K$ of the oscillator signal according to the following mathematical function:

$$k_T = 1/k_S * (1 - T_K/T_0),$$

where $k_S$ and $T_0$ are circuit-specific constants independent of the degree of coupling $k_T$.

4. Circuit arrangement according to Claim 2, characterized in that, between the output of the comparator (14) and the input of the transmission system (10), a change-over switch (24) is disposed, which optionally creates a direct connection (26) or a connection via an inverter (28), and that the counter assembly (18) or the computer determines the degree of coupling $k_T$ from the period $T_{K1}$ of the oscillator signal in the one switched position and the period $T_{K2}$ of the oscillator signal in the other switched position from the following mathematical function:

$$k_T = 1/k_S * (T_{K2}/2T_0 - T_{K1}/2T_0),$$

where $k_S$ and $T_0$ are circuit-specific constants independent of the degree of coupling $k_T$ and $T_0$ can be determined in a preceding or cyclical calibration operation from the following mathematical function:

$$2T_0 = T_{K1} + T_{K2}.$$

5. Circuit arrangement according to Claim 3 or 4, characterized in that the counter assembly (18) comprises a first, settable counter (20) and a second counter (22), timed by a reference rhythm, wherein the oscillator signal is applied to the timing input of the first counter (20), the output of the first counter (20) is connected to the gate of the second counter (22) and the reference rhythm is applied to the timing input of the second counter (22).

6. Circuit arrangement according to one of Claims 1 to 5, characterized in that, between the output of the comparator (14) and the input of the transmission system (10), a switch (24) is disposed, which creates a connection or an interruption as desired.

7. Circuit arrangement according to one of Claims 1 to 6, characterized in that the integrator (12) is an inverting amplifier, between the output and inverting input of which a capacitor (C) is disposed, and that the adder (16) comprises a first charging resistor ($R_{I1}$) and a second charging resistor ($R_{I2}$), which are connected to the inverting input.

8. Circuit arrangement according to one of Claims 1 to 7, characterized in that the comparator (14) is a feedback-coupled, non-inverting amplifier.

9. Circuit arrangement according to one of Claims 1 to 8, wherein the transmission system (10) is a differential transformer, characterized in that the input of the transmission system (10) is connected to the primary winding and the output of the transmission system (10) to the secondary windings, having series-opposing connection, of the differential transformer (10).

**Revendications**

1. Circuit pour déterminer le degré de couplage ($K_T$) dans un système de transmission variable (10) en utilisant un oscillateur qui alimente l'entrée du système de transmission (10) et qui comprend un circuit série formé d'un intégrateur (12) et d'un comparateur (14), la sortie du comparateur (14) étant reliée à l'entrée du système de transmission (10) et, par un additionneur (16), à la sortie du système de transmission (10) et à l'entrée de l'intégrateur (12), <u>caractérisé en ce</u> que,

  a) le système de transmission (10) présente un comportement différentiel en transmission électrique de façon que le degré de couplage ($K_T$) se représente linéairement pendant la durée de période ($T_K$) de l'oscillateur

b) la durée de période ($T_K$) de l'oscillateur étant mesurée au moyen d'un circuit compteur (18) servant de circuit d'évaluation et d'indication ou d'un calculateur,

c) dans lequel, à l'aide de constantes ($T_1$, $T_0$) spécifiques au circuit dépendant du degré de couplage ($K_T$), qui peuvent être calculées par les paramètres du circuit ou qui sont mesurées dans un procédé de calibrage déclenché ou cyclique, le degré de couplage ($K_T$) est détecté par la différence de la durée de période ($T_0$) de l'oscillateur pour système de transmission (10) débranché et de la durée de période ($T_K$) pour système de transmission (10) branché, cette différence étant rapportée à la constante ($T_1$) spécifique au circuit.

2. Circuit suivant la revendication 1, <u>caractérisé en ce</u> que les éléments de circuit définissant la fréquence de l'oscillateur sont définis de façon que la durée de période moyenne $T_K$ du signal de l'oscillateur soit essentiellement plus longue que la constante de temps $T_T$ du système de transmission, de manière telle que l'expression (1 - exp($-T_K/2T_T$)) varie jusqu'à un écart par rapport à 1 situé dans l'ordre de grandeur de la résolution de mesure du circuit que l'on peut atteindre.

3. Circuit suivant la revendication 2, <u>caractérisé en ce</u> que le circuit compteur (18) ou le calculateur détecte le degré de couplage $K_T$ de la durée de période $T_K$ du signal de l'oscillateur d'après la fonction mathématique suivante:

$$K_T = 1/k_S * (1 - T_K/T_0)$$

$k_S$ et $T_0$ étant des constantes spécifiques du circuit dépendant du degré de couplage $K_T$.

4. Circuit suivant la revendication 2, <u>caractérisé en ce</u> qu'entre la sortie du comparateur (14) et l'entrée du système de transmission (10), est prévu un contact (24) qui, au choix, forme une liaison directe (26) ou une liaison par un inverseur (28), et en ce que le circuit compteur (18) ou le calculateur détecte le degré de couplage par la durée de période $T_{K1}$ du signal de l'oscillateur, dans le premier état du contact, et la durée de période $T_{K2}$ du signal de l'oscillateur, dans l'autre état du contact, suivant la fonction mathématique suivante:

$$k_T = 1/k_S * (T_{K2}/2T_0 - T_{K1}/2T_0)$$

où $k_S$ et $T_0$ sont de constantes spécifiques au circuit dépendant du degré de couplage $k_T$, et $T_0$ peut être déterminé dans un procédé de calibrage déclenchable ou cyclique suivant la fonction mathématique suivante:

$$2T_0 = T_{K1} + T_{K2}$$

5. Circuit suivant la revendication 3 ou 4, <u>caractérisé en ce</u> que le circuit compteur (18) présente un premier compteur réglable (20) et un second compteur (22) synchronisé par une synchronisation de référence, le signal de l'oscillateur étant relié à l'entrée de synchronisation du premier compteur (20), la sortie du premier compteur (20) étant relié à la porte du second compteur (22) et la synchronisation de référence étant reliée à l'entrée de synchronisation du second compteur (22).

6. Circuit suivant une des revendications 1 à 5, <u>caractérisé en ce</u> qu'entre la sortie du comparateur (14) et l'entrée du système de transmission (10), est prévu un commutateur (24) qui crée, au choix, une liaison ou une interruption.

7. Circuit suivant une des revendications 1 à 6, <u>caractérisé en ce</u> que l'intégrateur (12) est un amplificateur inverseur dans lequel, entre la sortie et l'entrée inverseuse, est monté un condensateur (C) et en ce que l'additionneur (16) comprend une première résistance de charge ($R_{l1}$) et une seconde résistance de charge ($R_{l2}$) qui sont reliées à l'entrée inverseuse.

8. Circuit suivant une des revendications 1 à 7, <u>caractérisé en ce</u> que le comparateur (14) est un amplificateur non inverseur à contre-réaction.

9. Circuit suivant une des revendications 1 à 8, dans lequel le système de transmission (10) est un transformateur différentiel, caractérisé en ce que l'entrée du système de transmission (10) est reliée à l'enroulement primaire et en ce que la sortie du système de transmission (10) est reliée aux enroulements secondaires du transformateur différentiel (10), qui sont montés en série, mais en sens inverse.

Fig. 1

EP 0 633 454 B1

Fig. 2

Fig. 3

Fig. 4

Fig. 5

$U_{SV+}$

$U_{S+}$

$U_{S-}$

$U_{SV-}$

$T_0$

$T_K$

Fig. 6